Europäisches Patentamt

European Patent Office

Office européen des brevets

(19)

(11)  **EP 0 427 020 B1**

(12)  **EUROPÄISCHE PATENTSCHRIFT**

(45) Veröffentlichungstag und Bekanntmachung des Hinweises auf die Patenterteilung:
**17.04.1996  Patentblatt 1996/16**

(51) Int. Cl.$^6$: **B23K 1/20**
// B23K35/38

(21) Anmeldenummer: **90119914.1**

(22) Anmeldetag: **17.10.1990**

(54) **Verfahren und Vorrichtung zur Verarbeitung von zu verlötenden Fügepartnern**

Method and device for processing soldering joint partners

Méthode et procédé de traitement de partenaires de joints de brasage

(84) Benannte Vertragsstaaten:
**AT BE CH DE DK ES FR GB GR IT LI LU NL SE**

(30) Priorität: **06.11.1989 DE 3936955**
**11.10.1990 DE 4032328**

(43) Veröffentlichungstag der Anmeldung:
**15.05.1991  Patentblatt 1991/20**

(73) Patentinhaber: **HERBERT STRECKFUSS MASCHINENBAU- UND VERWALTUNGS-KG**
**D-76344 Eggenstein (DE)**

(72) Erfinder:
• **Liedke, Volker, Dipl.-Ing.**
**W-8751 Elsenfeld/Eichelsbach (DE)**
• **Albrecht, Hans-Jürgen**
**O-1093 Berlin (DE)**

• **John, Wilfred**
**O-1153 Berlin (DE)**
• **Grasmann, Karl Heinz**
**W-6985 Stadtprozelten (DE)**
• **Wittrich, Harald**
**O-1122 Berlin (DE)**
• **Scheel, Wolfgang**
**O-1020 Berlin (DE)**

(74) Vertreter: **Dipl.-Ing. Heiner Lichti**
**Dipl.-Phys. Dr.rer.nat. Jost Lempert**
**Dipl.-Ing. Hartmut Lasch**
**Postfach 41 07 60**
**D-76207 Karlsruhe (DE)**

(56) Entgegenhaltungen:
**EP-A- 0 109 892          EP-A- 0 371 693**
**FR-A- 2 560 797          GB-A- 2 144 669**

EP 0 427 020 B1

**Beschreibung**

Die Erfindung betrifft ein Verfahren zur Verarbeitung von mit elektronischen Bauelementen bestückten Leiterplatten gemäß dem Oberbegriff des Patentanspruchs 1 und eine Vorrichtung zur Durchführung des Verfahrens gemäß dem Oberbegriff des Patentanspruchs 20.

Im Zuge der zunehmenden Automatisierung der Fertigungstechnik in der Elektronikindustrie gewinnen die Lötverfahren zunehmend an Bedeutung. Bei dem bisher bekannten, allgemein zum Stand der Technik gehörenden Verarbeitungsverfahren, das in zahlreichen Lötanlagen realisiert ist, werden die Fügepartner, d.h. die mit elektrischen Bauteilen bestückten Leiterplatten, oder deren miteinander zu verlötende metallische Lötanschlußflächen mit einem Flußmittel benetzt, zueinander in eine vorbestimmte Relativposition gebracht und dann einer Lötvorrichtung zugeführt, in der der eigentliche Lötvorgang erfolgt. Durch die Einwirkung des Flußmittels wird die Lötfreudigkeit der Kontakt- oder Lötanschlußflächen, d.h. die Bindungskräfte innerhalb der Grenzflächen erster Fügepartner/Lot bzw. Lot/zweiter Fügepartner erhöht. Darüber hinaus läßt sich durch Flußmittel die Oberflächenspannung des Lots vergrößern, so daß einer Brückenbildung zwischen zwei benachbarten Lötstellen vorgebeugt wird. Die fügetechnisch notwendigen Flußmittel bzw. die Flußmittelrückstände müssen nach dem Löten entfernt werden, da sie u.a. die elektrische Funktion der Fügepartner beeinträchtigen und korrosiv auf diese wirken können. Nach dem Lötvorgang durchlaufen die miteinander verlöteten Fügepartner daher üblicherweise ein naß-chemisches FCKW- oder CKW-Reinigungsbad, in dem die Flußmittelrückstände beseitigt werden.

Der Einsatz dieser Waschflüssigkeiten unterliegt jedoch zum Schutz der Umwelt starken Einschränkungen und hat hohe Investitionen hinsichtlich der Abluft- und Abwasserreinigung notwendig gemacht.

Aus der DE-A-35 08 005 (=FR-A-25 60 797) ist ein Verfahren zum Reinigen der Leiterstifte einer Halbleiterpackung sowie der Leiterstifte einer Leiterrahmen-Anordnung bekannt, bei dem das Reinigen im Plasma erfolgt. Nicht beschrieben wird die Plasmabehandlung einer bestückten Leiterplatte. Soweit das Einlöten von elektronischen Bauelementen in eine Leiterplatte beschrieben wird, erfolgt die Plasmabehandlung der Leiterstifte der Bauelemente bzw. Packungen vor dem Einsetzen der Leiterstifte in die Stiftaufnahmefassungen der Leiterplatten. Das Löten der bestückten Leiterplatten erfolgt erst, nachdem die Bauelemente mit den bereits gereinigten Leiterstiften in die Leiterplatten eingesetzt worden sind. Auf diese Weise kann die Plasmabehandlung nicht die Lötfreudigkeit der Leiterplatten erhöhen, also auch nicht für die erforderliche Lötfreudigkeit der bestückten Leiterplatten sorgen.

In der GB-A-21 44 669 wird das Reinigen von elektrischen Kontakten von Relais und Schaltern in einer Kammer mit Hilfe von Plasma beschrieben. Das Löten und insbesondere das Löten von bestückten Leiterplatten ist nicht angesprochen.

Die EP-A 0 371 693 - Artikel 54(3) EPÜ - zeigt ein Reflow-Löten insbesondere von "Flip-Chip Components". Sowohl die Vorbehandlung als auch das Löten erfolgt unter Plasma und die Plasmavorbehandlung hat den Zweck, ohne flüssiges Flußmittel arbeiten zu können. Nicht angesprochen ist jedoch das Löten bestückter Leiterplatten. Ferner ist nicht vorgesehen, die bestückten Leiterplatten zunächst einer Vorbehandlungsstation zuzuführen, um sie dann zu einer Lötmaschine zu fördern, in der der eigentliche Lötvorgang ausgeführt wird.

In der WO-A-90/10518 - Artikel 54(3) EPÜ - ist ein Reflow-Lötenverfahren erläutert. Die Vorbehandlung erfolgt im Plasma, wobei dies der Vermeidung des Einsatzes von Flußmittel dienen soll. Der eigentliche Lötvorgang, d.h. das Aufschmelzen des Lotes, kann sowohl unter Plasma als auch ohne Plasma durchgeführt werden. Nicht beschrieben oder gezeigt ist jedoch, daß bestückte Leiterplatten zunächst einer Vorbehandlungsstation zugeführt werden und daß sie nach der Vorbehandlung aus der Vorbehandlungsstation zu einer Lötmaschine gefördert werden, in der eigentliche Lötvorgang ausgeführt wird. Erfindungsgemäß wird jedoch gerade davon ausgegangen, daß die bestückten Leiterplatten aufeinanderfolgend mehrere Stationen durchlaufen. Entsprechende Lötanlagen werden industriell am häufigsten eingesetzt und bei ihnen fallen wegen der Produktion hoher Stückzahlen die größten Mengen an chlorierten Kohlenwasserstoffen und Fluorwasserstoffen an.

Aufgabe der Erfindung ist es, ein Verfahren zur Verarbeitung von mit elektronischen Bauelementen bestückten Leiterplatten zu schaffen, bei dem bei der Vorbehandlung soweit wie möglich auf Flußmittel verzichtet werden kann, sowie eine Vorrichtung zur Durchführung dieses Verfahrens vorzusehen.

Diese Aufgabe wird hinsichtlich des Verfahrens durch die Merkmale des Patentanspruchs 1 gelöst. Gemäß dessen kennzeichnendem Teil ist vorgesehen, daß in der Vorbehandlungsstation, die durch eine Niederdruck-Prozeßkammer gebildet ist, als Vorbehandlung der bestückten Leiterplatten vor dem Lötvorgang statt einer Behandlung mit einem Flußmittel eine Plasmabehandlung mit einem Prozeßgas erfolgt.

Es ist gefunden worden, daß ohne Verschlechterung der Lötqualität auf den Einsatz von Flußmittel vollständig verzichtet werden kann, wenn die bestückten Leiterplatten einer Plasmabehandlung unterworfen werden. Durch das erfindungsgemäße Verfahren ist somit ein wesentlicher Durchbruch erzielt worden, der es erlaubt, bei der Massenfertigung von gelöteten bestückten Leiterplatten auf den Einsatz von Flußmittel und daher auch auf den Einsatz von FCKW- oder CKW-haltigen Waschfluiden zu verzichten.

Durch die Plasmavorbehandlung, d.h. die Einwirkung eines durch Anlegen einer hochfrequenten Wechselspannung in ionisierten Zustand versetzten Prozeßgases, werden Passiv- und Oxidschichten auf den Oberflächen der Fügepartner dekapiert, einer nochmaligen Kontamination vorgebeugt und somit metallurgisch reaktionsfähige Oberflächen für den Lötvorgang bereitgestellt. Durch die Plasmavorbehandlung läßt sich demnach die Lötfreudigkeit der Fügepartner ohne den Einsatz von Flußmitteln erhöhen, wodurch Flußmittel mit einem geringeren Feststoffanteil einsetzbar sind oder gar die Notwendigkeit des Flußmitteleinsatzes entfällt. Die Verwendung eines Prozeßgases ermöglicht im Vergleich zu naßchemischen Verfahren eine einfache Prozeßkontrolle, wobei auch umweltgefährdende Stoffe leicht beherrschbar sind, da die Prozeßgase im geschlossenen Kreislauf geführt werden und schädliche Stoffe auf einfache Weise - z.B. durch einen Adsorber - entfernbar sind.

Bevorzugterweise werden die in den Patentansprüche 2 bis 8 aufgeführten Prozeßgase eingesetzt. Bei den in den Patentansprüchen 3, 4, 5 oder 6 beanspruchten Prozeßgaszusammensetzungen erfolgt die Dekapierung der Oberfläche der Fügepartner bevorzugterweise durch Reduktion der sich auf Metalloberflächen befindenden Passiv- und Oxidschichten, während die Erhöhung der Lötfreudigkeit der Fügepartner bei den in den Patentansprüchen 7 und 8 beanspruchten Stoffkombinationen im wesentlichen auf einer oxidierenden Wirkung des Prozeßgases beruht. Die Auswahl der Prozeßgase erfolgt abhängig von den Fertigungsbedingungen nach Art und Quantität der Passiv- und Oxidschichten.

Die Anwendung eines Niederdruckplasmas gemäß den Patentansprüchen 9 und 10 ermöglicht die Behandlung der Leiterplatten bei geringen Prozeßtemperaturen, so daß einer thermischen Schädigung der Fügepartner vorgebeugt wird.

Die Zwischenspeicherung gemäß den Patentansprüchen 11 und 12 der bestückten Leiterplatten kann in gasdichten Behältnissen vorgenommen werden, wobei im Inneren der Behältnisse vorzugsweise eine Schutzgasatmosphäre oder zumindest eine weitgehend $O_2$-freie Atmosphäre herrscht. Bei der Verwendung von bspw. $N_2$ als Schutzgas werden die aktiven Zentren der Fügeflächen durch Nitridbildung passiviert, so daß eine nachfolgende Kontamination unterdrückt wird.

In den Zwischenspeichern können zur Vorbereitung auf den sich anschließenden Fertigungsschritt gemäß Patentanspruch 13 Einrichtungen zur Temperierung vorgesehen sein.

Mit der vorteilhaften Weiterbildung gemäß Patentanspruch 15 werden die bestückten Leiterplatten zur Vermeidung einer Reoxidation zwischen der Plasmabehandlung und dem sich anschließenden Lötvorgang mit einem Schutzgas beaufschlagt.

Bei geringen Losgrößen läßt sich eine abschnittsweise betriebene geschlossene Plasmaprozeßkammer verwenden, die auf einfache Weise an unterschiedliche Betriebsbedingungen und Fügepartnergeometrien anpaßbar ist.

Bei der Großserienfertigung wird es bevorzugt, die Plasmabehandlung in einer kontinuierlich betriebenen Prozeßkammer durchzuführen.

Besonders vorteilhaft läßt sich das Verfahren auf SMD oder gemischtbestückten COB/SMD-Baugruppen anwenden, wenn die Bauelemente gemäß Patentanspruch 18 auf den Leiterplatten fixiert werden.

Ein besonders wirtschaftliches Verfahren ergibt sich bei der gleichzeitigen Plasmabehandlung einer Vielzahl von bestückten Leiterplatten.

Die Vorrichtung nach Patentanspruch 20 ermöglicht die Durchführung des Verfahrens nach Patentanspruch 1, wobei vorteilhafterweise gemäß Patentanspruch 21 zur Plasmabehandlung eine an sich bekannte Niederdruck-Prozeßkammer einsetzbar ist. Mit einer derartigen Einrichtung lassen sich bereits bestehende Lötvorrichtungen auf eine flußmittelfreie oder -arme Fertigung umrüsten.

Vorzugsweise werden der Prozeßkammer Zwischenspeicher zugeordnet, in denen die bestückten Leiterplatten vor und/oder nach der Plasmabehandlung zwischengespeichert werden.

Gemäß den Patentansprüchen 22 und 25 ermöglicht die Absperrung der Prozeßkammer und der Zwischenspeicher durch jeweils ein Schleusensystem eine kontinuierliche Plasmabehandlung der bestückten Leiterplatten in einem Durchlaufsystem.

Durch die vorteilhafte Weiterbildung gemäß den Patentansprüchen 26 und 27 ist eine gleichmäßige Verteilung des Gasplasmas über die Oberfläche der bestückten Leiterplatten gewährleistet.

Durch die Weiterbildung gemäß Patentanspruch 28 können der erste und zweite Zwischenspeicher an die Umgebungsbedingungen bzw. die Betriebsbedingungen der Prozeßkammer angepaßt werden, wobei es besonders vorteilhaft ist, wenn die Zwischenspeicher mit einem Schutzgas belüftbar sind.

Die Weiterbildung gemäß den Patentansprüchen 31 bis 34 ermöglichen die Integration der vorgenannten Bauelemente oder einer Kombination dieser Bauelemente zu einer kompakten Gesamtanlage, durch die eine wirtschaftliche Verlötung von bestückten Leiterplatten gewährleistet ist. Die Anordnung zumindest der Plasmabehandlungskammer und der Lötvorrichtung in einem gemeinsamen Durchlauftunnelsystem gewährleistet bei minimalem verfahrens- und vorrichtungstechnischen Aufwand, daß die plasmabehandelten bestückten Leiterplatten unter Verhinderung einer Reoxidation der Lötanschlußflächen der Lötvorrichtung zugeführt werden.

Durch die Maßnahme, im Inneren der Plasmakammer eingangs- und ausgangsseitig jeweils eine Beruhigungszone auszubilden, kann der Einfluß des Öffnens der Schleusentore auf die Gaszusammensetzung in der Plasmakammer wesentlich verringert werden, und die Leiterplatten können in den Beruhigungszonen auf die Prozeßtemperatur erwärmt werden.

Die vorteilhafte Weiterbildung gemäß Patentanspruch 38 vermindert die Neigung zur Lotbrückenbildung, so daß eine weitgehend lötfehlerfreie Fertigung ermöglicht ist.

Gemäß den Patentansprüchen 39 und 40 ist die erfindungsgemäße Vorrichtung in Verbindung mit einer Wellenlötvorrichtung bzw. einer Reflow-Lötvorrichtung anwendbar, so daß u.a. sowohl Mischbestückungen mit konventionellen Bauteilen uns SMDs (Wellen-Lötvorrichtungen) als auch reine SMD-Bestückungen (Reflow-Lötvorrichtungen) kontinuierlich verarbeitbar sind.

Weitere vorteilhafte Weiterbildungen sind Gegenstand der übrigen Patentansprüche.

Die Erfindung wird nachstehend anhand bevorzugter Ausführungsbeispiele unter Bezugnahme auf die Figuren näher erläutert. Es zeigen:

Figur 1:  ein erstes Ausführungsbeispiel einer Vorrichtung zur Verarbeitung von mit elektronischen Bauelementen bestückten Leiterplatten,

Figur 2:  ein zweites Ausführungsbeispiel einer Vorrichtung zur Verarbeitung bestückter Leiterplatten und

Figur 3:  eine Teilansicht der Vorrichtung aus Figur 2.

Das Verfahren läßt sich u.a. bei der flußmittelfreien bzw. -reduzierten Lötmontage von SMD-Bauelementen sowie von COB(Chip on board)- oder THM(through hole mounted)-Bauelementen auf Flachbaugruppenträgern, wie bspw. Leiterplatten, einsetzen.

Bevor auf Ausführungsbeispiele der Erfindung eingegangen wird, sei im folgenden kurz auf die physikalisch-chemischen Zusammenhänge bei einer Plasmavorbehandlung eingegangen.

Die bspw. Sn, Pb, Cu, Ag, Pd, Ni, Au oder deren Legierungen beinhaltenden Lötanschlußflächen werden durch die Plasmavorbehandlung dekapiert, wodurch die Lötfreudigkeit der Fügepartner wesentlich erhöht wird.

Der Reaktionsmechanismus bei der Dekapierung der metallischen Oberflächen, die eine organische Kontaminationsschicht tragen, kann beim Einsatz eines $H_2/CH_4$-Prozeßgases wie folgt dargestellt werden.

Die metallischen Oberflächen sind mit Kohlenwasserstoff-Polymeren ($C_xH_y$) belegt. Aktiver Wasserstoff reduziert die Polymere zu Methylradikalen und entfernt damit das Polymer von den Metalloberflächen bzw. Metalloxidoberflächen. Der aktive Wasserstoff reduziert die Metalloxide zu Metall:

$$MeO_x + 2\,xH^* \rightarrow Me + xH_2 + xH_2O\uparrow$$

Im $H_2/CH_4$-Plasma liegen neben aktiven Wasserstoffspezies auch aktive Methylradikale vor, die einen Abtrag der Metalloberfläche bewirken (die entstehenden Metall-Alkyle sind flüchtig).

$$Me + X \cdot CH_3{}^* \rightarrow Me\,(CH_3)x\uparrow$$

Die Kombination von Reduktions- und Alkylierungsreaktionen bewirkt einen Abtrag sowohl organischer als auch oxidischer und metallischer Oberflächenfilme und damit einen Reinigungsprozeß.

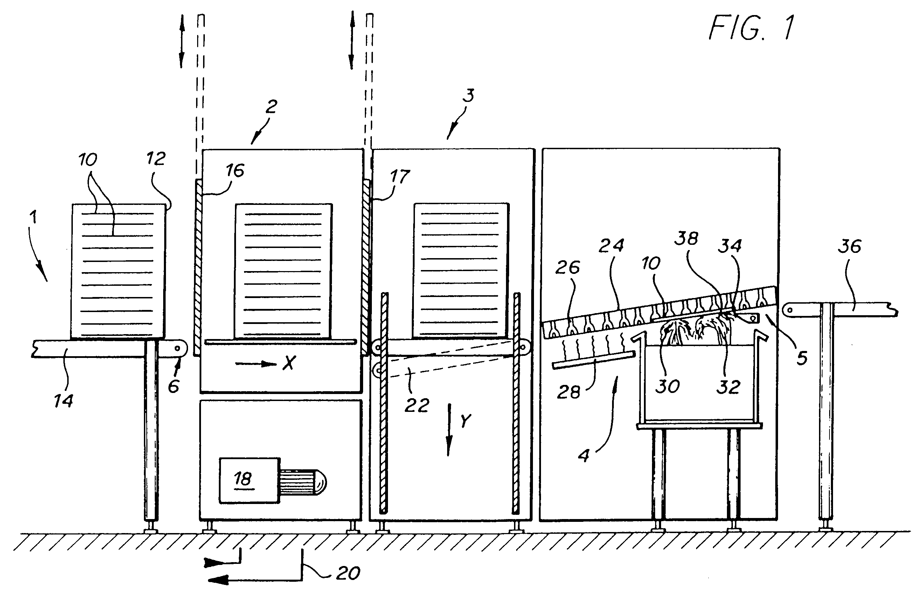

Die in Figur 1 gezeigte Vorrichtung hat eine Zuführstation 1, eine Niederdruck-Prozeßkammer 2, einen beheizbaren Zwischenspeicher 3 und eine Lötvorrichtung 4, vorzugsweise eine Wellen-Lötvorrichtung, der eine Schutzgasaufblasstation 5 zugeordnet ist. Die vorstehend genannten Bearbeitungsstationen sind über ein Fördersystem 6 verbunden, so daß eine weitgehend automatisierte Fertigung ermöglicht ist. Im folgenden ist auf die konkrete Beschreibung der Elemente des Fördersystems 6 verzichtet, da diese bereits an sich von herkömmlichen Lötvorrichtungen bekannt sind. Da die gesamte beschriebene Anlage aus einzelnen Modulen zusammengesetzt ist, können bereits bestehende, herkömmliche Lötvorrichtungen auf einfache Weise durch Zuordnung beispielsweise der Prozeßkammer 2 und des Zwischenspeichers 3 erweitert werden.

Eine vorbestimmte Anzahl von in einem nicht gezeigten Bestückungsautomaten bestückten Leiterplatten 10 werden in einem Stapelmagazin 12 angeordnet, und dieses wird über ein Zuführband 14 der Prozeßkammer 2 zugeführt. Für das Plasmaverfahren können herkömmliche Niederdruck-Prozeßkammern verwendet werden. Derartige Prozeßkammern sind im Labormaßstab mit einem Volumen von 10 Litern bis hin zum industriellen Maßstab mit einem Volumen von mehreren $m^3$ verfügbar. Da Niederdruck-Prozeßkammern bereits beispielsweise aus der Kunststofflackiertechnik zur Vorbehandlung von zu lackierenden Kunststoffflächen hinlänglich bekannt sind, seien im folgenden lediglich die zum Verständnis der beschriebenen Vorrichtung wichtigen Bauelemente beschrieben. Die Niederdruck-Prozeßkammer 2 ist durch zwei Kammertüren 16 und 17 absperrbar. Es ist jedoch auch möglich und wird bevorzugt, die Prozeßkammer über zwei in Transportrichtung X angeordnete Schleusen vakuumdicht abzusperren. Das Innere der mit Quarz ausgekleideten Prozeßkammer 2 ist mittels einer Vakuumpumpe 18 auf den vorbestimmten Prozeßdruck evakuierbar. Die Vakuumpumpe 18 ist derart ausgelegt, daß das Innere der Prozeßkammer 2 innerhalb eines Zeitraums von weniger als 2 min auf den Prozeßdruck bringbar ist. An die Prozeßkammer 2 sind Leitungen 20 zur Zu- und Abführung der Prozeßgase angeschlossen. Die abgeführten Prozeßgase werden einer nicht gezeigten Gasreinigung, beispielsweise durch einen Adsorber, unterzogen, so daß eventuell entstehende umweltschädliche Reaktionsprodukte von dem im Kreislauf gefahrenen Prozeßgas abgetrennt werden.

Der Prozeßkammer 2 ist ein Hochfrequenzgenerator, ein sog. Magnetron (nicht gezeigt), zugeordnet, mit dem das Prozeßgas in einen ionisierten Zustand (Plasma) bringbar ist.

Im Anschluß an die Prozeßkammer 2 ist ein beheizbarer Zwischenspeicher 3 angeordnet, in den das Stapelmagazin 12 aus der Prozeßkammer 2 mittels einer nicht gezeigten Transportvorrichtung überführbar ist. Der Zwischenspeicher 3 ist mittels einer Zusatzheizung auf eine für den sich anschließenden Lötvorgang geeignete Temperatur erwärmt.

Die Leiterplatten 10 werden über eine Ausgabeeinrichtung 22 nacheinander einzeln aus dem Stapelmagazin 12 entnommen, wobei der Leiterplattenstapel in Y-Richtung absenkbar ist, so daß die jeweils zu entnehmende Leiterplatte 10 auf die Höhe der Förderebene gebracht wird. Die Ausgabeeinrichtung 22 kann auch in Form eines mit einem Leiterplattengreifer versehenen Handlingsgeräts ausgebildet werden, so daß das Absenken des Stapelmagazins 12 entfallen kann. Die Fassungskapazität des Stapelmagazins 12 und die Zyklusdauer der Plasmavorbehandlung sind derart ausgelegt, daß eine kontinuierliche Zuführung von Leiterplatten 10 zur Lötmaschine gewährleistet ist.

An die Ausgabeeinrichtung 22 schließt sich ein Förderband 24 an, das mit Aufnahmen 26 zur Fixierung der Leiterplatten 10 oder eines nicht gezeigten Hilfsrahmens versehen ist, der seinerseits die Leiterplatten 10 aufnimmt. Die zu verlötende Leiterplatte ist mit den SMDs und den Anschlußelementen der konventionellen Bauteile in der Figur nach unten weisend angeordnet, so daß die Lötstellen in der Lötmaschine 4 benetzt werden. Das Förderband 24 ist gegenüber der Horizontalen um einen vorbestimmten Winkel von ca. 7° angestellt. Parallel zum Anfangsabschnitt des Förderbands 24 ist eine - beispielsweise mit Infrarotelementen betriebene - Vorheizung 28 angeordnet, mit der die Leiterplatten 10 vorgewärmt werden.

Im Anschluß an die Vorheizung 28 ist eine an sich bekannte Doppelwellen-Lötvorrichtung 4 vorgesehen. Eine derartige Lötvorrichtung 4 arbeitet mit zwei Lötwellen 30, 32, wobei in der in Transportrichtung X gesehenen ersten Welle 30 eine turbulente Strömung ausgebildet ist, die zu einer vollständigen Benetzung der Lötstellen führt, da durch die unterschiedlichen Strömungen innerhalb der Welle 30 das Lot auch entgegen der Transportrichtung X der Leiterplatte fließt. In der zweiten Welle 32 strömt das Lot in einer laminaren Strömung entgegen der Transportrichtung X, wobei überflüssiges Lot von der Lötstelle abgeführt wird.

In den Zwischenraum der zweiten Lotwelle 32 und dem frisch benetzten Abschnitt der bestückten Leiterplatte wird mittels einer sich über die Breite der Lotwelle erstreckenden Breitschlitzdüse 34 ein Schutzgas, beispielsweise $N_2$, aufgeblasen, dessen Temperatur unterhalb des Lot-Liquiduspunktes liegt, so daß sich unmittelbar im Anschluß an die zweite Welle 32 eine Schutzgaszone ausbildet, durch die die laminare Strömung der Welle nicht beeinflußt ist.

Die abschließende Station des Ausführungsbeispiels bildet eine Abführeinrichtung 36 für die Leiterplatten 10, der vorzugsweise eine nicht gezeigte Ausgabestation mit einem Stapelmagazin zur transportgerechten Lagerung der verlöteten Leiterplatten 10 zugeordnet ist. Die Übergabe der Leiterplatten 10 bzw. des Stapelmagazins 12 zwischen den vorstehend beschriebenen Fertigungsstationen kann durch an sich bekannte Handlinggeräte, Schiebersysteme o.ä. erfolgen. An die Abführeinrichtung 36 können sich selbstverständlich weitere Fertigungsstationen zur Verarbeitung der Leiterplatten anschließen.

Die Fertigungsschritte des erfindungsgemäßen Verfahrens werden im folgenden anhand des Ausführungsbeispiels erläutert.

Die in dem Stapelmagazin 12 übereinanderliegend angeordneten, bestückten Leiterplatten 10 werden von der Zuführstation 1, beispielsweise über ein Rollenband in die diskontinuierlich betriebene Prozeßkammer 2 gefördert, wobei die zuführstationsseitige Schleuse durch eine in der Figur nach oben verschiebbare Kammertür 16 gebildet ist. Die Prozeßkammer 2 wird durch Absenken der Kammertür 16 vakuumdicht verschlossen und über die Vakuumpumpe 18 auf den Prozeßdruck von beispielsweise 100 Pa gebracht, wobei in der Prozeßkammer 2 z.B. eine Gasatmosphäre bestehend aus 95 Volumenanteilen $H_2$ und 1 Volumenanteil $CH_4$ vorliegt. Der Vorteil des Niederdruck-Plasmaverfahrens liegt darin, daß die freien Weglängen der Gasmoleküle aufgrund des anliegenden Vakuums groß sind, so daß sich das Plasma bereits bei Prozeßtemperaturen zwischen 60 und 100°C bildet und so einer thermischen Schädigung der Leiterplatten vorgebeugt ist. Das Prozeßgasgemisch wird über das Magnetron in einen ionisierten Zustand versetzt, wobei vorzugsweise Frequenzen im Gigaherz-Bereich (Mikrowelle) eingesetzt werden. Das entstandene Gasplasma besteht aus ungeladenen Molekülen, Ionen und Radikalen des Prozeßgases, die mit der Oberfläche der Fügepartner, wie vorstehend beschrieben, chemische Reaktionen eingehen oder durch Impulsübertragung aus der Oberfläche der Leiterplatte Teilchen "herausschlagen". Auf diese Weise werden auf den Leiterbahnen und auf den Bauelementen entstandene Passiv- und Oxidschichten entfernt. Durch die damit verbundene Erhöhung der Lötfreudigkeit ist die Verwendung von Flußmitteln zu diesem Zweck entbehrlich oder zumindest die Verwendung von weniger feststoffhaltigen Flußmitteln ermöglicht. Das Gasplasma zeichnet sich durch eine hervorragende Spaltgängigkeit aus, so daß auch schlecht zugängliche Abschnitte der bestückten Leiterplatten 10 erreicht werden.

Die Reaktionsprodukte werden über die Vakuumpumpe 18 abgesaugt und der Prozeßkammer 2 werden kontinuierlich neu aufbereitete Prozeßgase zugeführt. Die Plasmabehandlung ist nach einer Einwirkzeit von beispielsweise 1,5 min beendet, wonach die Prozeßgaszufuhr unterbrochen, vorhandene Prozeßgase abgepumpt und die Prozeßkammer 2 belüftet wird. Nach der Plasmavorbehandlung werden die Kammertüren 16, 17 nach oben hin geöffnet und das behandelte Stapelmagazin durch die lötmaschinenseitige Kammertür 17 über das Fördersystem 6 in den Zwischenspeicher 3 gefördert, während über die Zuführstation 1 ein nächstes Stapelmagazin 12 zugeführt wird.

Die Leiterplatten 10 werden im Zwischenspeicher 3 auf eine für die sich anschließende Verlötung geeignete Temperatur gebracht und über die Ausgabeeinrichtung 22 einzeln aus dem Stapel entnommen und in den Aufnahmen 26 des Förderbands 24 festgelegt und von diesem vorbei an der Vorheizung 28 hin zur Doppelwellen-Lötvorrichtung 4 transportiert. In dieser wird das Lot in an sich bekannter Weise aufgetragen, so daß die Bauteile mit den Leiterplatten verlötet werden.

In der erfindungsgemäßen Vorrichtung wird auf die zu verlötende Leiterplatte 2 nach der zweiten Welle 32 über die Breitschlitzdüse 34 ein erwärmtes Schutzgas geblasen, so daß sich eine durch die Rückseite der zweiten Welle 32 und der Leiterplattenoberfläche begrenzte Schutzgaszone 38, ein sog. "Schutzgaskissen", ausbildet, durch das einer unerwünschten Lotbrückenbildung weiter vorgebeugt wird. Da insbesondere bei Wellen-Lötvorrichtungen die Gefahr einer Lotbrückenbildung besteht, ist es vorteilhaft, bei derartigen Anlagen das vorstehend beschriebene "Schutzgaskissen" zu verwenden, um auf diese Weise ohne die Anwendung von Flußmitteln eine qualitativ einwandfreie Lotverbindung zu erzielen.

Im Anschluß an die Doppelwellen-Lötvorrichtung 4 wird die bestückte Leiterplatte 10 von einer Abführeinrichtung 36 entnommen und einer weiteren Verarbeitung bzw. Lagerung zugeführt.

Es hat sich gezeigt, daß die Plasmavorbehandlung auch nach dem Verstreichen eines größeren Zeitraums von mehreren Stunden nur vernachlässigbar wenig ihrer Wirksamkeit verliert, so daß sich der eigentliche Lötvorgang nicht notwendigerweise unmittelbar an die Plasmabehandlung anschließen muß. Damit ist das erfindungsgemäße Verfahren nicht auf eine Anwendung in einer Online-Fertigung beschränkt, sondern es ist auch möglich, die Plasmavorbehandlung und den eigentlichen Lötvorgang an getrennten Orten mit einer Zwischenlagerung der bestückten Leiterplatten durchzuführen, oder die einzelnen Fügepartner, d.h. im vorliegenden Fall die Leiterplatte und die elektronischen Bauelemente, getrennt einer Plasmabehandlung zu unterziehen, die plasmavorbehandelten Fügepartner zwischenzulagern und bei Bedarf zu montieren und miteinander zu verlöten. Mit dem neuen Verfahren ist es bspw. möglich, die plasmabehandelten Fügepartner zur Verhinderung einer Kontaminierung in geeigneten Behältnissen unter Schutzgas aufzubewahren und erst nach einer längeren Lagerzeit oder nach einem Transport in dem Behältnis einem weiteren Fertigungsschnitt, wie z.B. Bestücken unter Schutzgas oder Löten, zuzuführen.

Im vorbeschriebenen Ausführungsbeispiel wird die Prozeßkammer 2 diskontinuierlich betrieben, es ist jedoch auch möglich, eine integrierte Lötvorrichtung mit einer kontinuierlich betriebenen Durchlaufprozeßkammer mit Durchlaufschleusensystemen zu verwenden.

Der Einfachheit halber werden im folgenden für die im ersten und im zweiten Ausführungsbeispiel einander entsprechenden Bauteile gleiche Bezugszeichen verwendet.

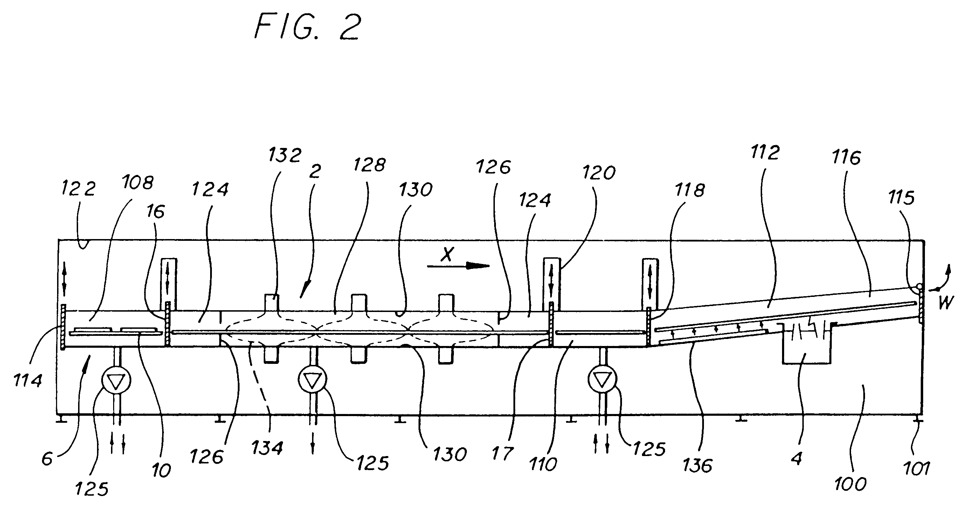

Wie aus Figur 2 ersichtlich ist, durchläuft bei einem kontinuierlich betriebenen System ein die Leiterplatten 10 tragendes Fördersystem 6 einen Tunnel 100, in dem eine zweite Evakuierungskammer 108, eine Prozeßkammer 2, eine erste Evakuierungskammer 110, ein Schutzgastunnel 112 und eine Lötvorrichtung 4 in Förderrichtung X hintereinanderliegend angeordnet sind.

Der Tunnel ist über eine Vielzahl verstellbarer Stützfüße 101 auf einer geeigneten Unterlage abgestützt, wobei durch die Verstellbarkeit der Stützfüße eine horizontale Ausrichtbarkeit des Tunnels 100 und somit des gesamten integrierten Lötsystems gewährleitstet ist. Im gezeigten Ausführungsbeispiel besteht das Fördersystem im Bereich der Evakuierungskammern 108, 110, der Prozeßkammer 2 und der Lötvorrichtung 4 aus getrennten Transporteinrichtungen, auf denen die Leiterplatten 10 mit Hilfsrahmen (nicht gezeigt) gelagert sind. Diese Hilfsrahmen können bereits in vorangegangenen Verfahrensschritten, z.B. beim Transport oder bei der Bestückung der Leiterplatten verwendet werden. Die einzelnen Transporteinrichtungen sind über diesen zugeordnete Steuereinrichtungen angesteuert, so daß ein kontinuierlicher Durchlauf von Leiterplatten 10 durch die Prozeßkammer 2 gewährtleistet ist.

Wie bereits beim ersten Ausführungsbeispiel erwähnt, wird auf eine detaillierte Beschreibung des Fördersystems 6 verzichtet, da handelsübliche, bereits bekannte Systeme zum Einsatz kommen können.

Der Tunnel 100 ist eingangs- und ausgangsseitig mit einem Einlaßtor 114 bzw. einem Auslaßtor 115 absperrbar. Das Einlaßtor 114 ist vorzugsweise als vakuumdichte Schleuse ausgebildet, während das Auslaßtor 115 als in Pfeilrichtung W nach oben verschwenkbares Klapptor ausgebildet ist. An dieses müssen hinsichtlich der Dichtigkeit nicht so hohe Anforderungen wie an das Einlaßtor 114 gestellt werden, da sich im Auslaßbereich 116 des Tunnels 100 eine Schutzgasatmosphäre mit einem Druck im Bereich des Umgebungsdruckes befindet und ein geringer Schutzgasverlust in Kauf genommen wird.

Die Prozeßkammer 2 ist durch vorzugsweise vertikal bewegbare Schleusentore 16, 17 gegenüber der ersten Evakuierungskammer 110 bzw. der zweiten Evakuierungskammer 108 vakuumdicht absperrbar. Letztere ist gegenüber dem Schutzgastunnel 112 und der Lötvorrichtung 4 durch ein Ausgangs-Schleusentor 116 vakuumdicht verschließbar. Im gezeigten Ausführungsbeispiel werden die Schleusentore 16, 17, 114 und 118 vertikal nach oben geöffnet und sind dabei jeweils in Führungsabschnitten 120 einer Tunnelhaube 122 geführt.

An die erste und zweite Evakuierungskammer 110, 108 sowie an die Prozeßkammer 2 ist jeweils eine Vakuumpumpe 125 angeschlossen, mit der die jeweils angeschlossene Kammer 110, 2, 108 z.B. auf den Prozeßdruck von 30 bis 40 Pa evakuierbar sind. Des weiteren ist jede der vorgenannten Kammern 110, 2, 108 mit einem Belüftungssystem versehen, um die Kammervolumina vom Vakuum auf Umgebungsdruck oder einem Druck im Bereich des Umgebungsdruckes zu bringen.

Um reaktive Prozeßgase oder andere Verunreinigungen zu entfernen und somit den strengen gesetzlichen Vorschriften zu genügen, können die Vakuumpumpen 125, insbesndere diejenige der Prozeßkammer 2, an eine Gasreinigungsanlage (nicht gezeigt) mit z.B. einem Absorber angeschlossen werden, so daß die Prozeßgase im Kreislauf verwendbar sind.

Die Belüftung, insbesondere die der Evakuierungskammern 110, 108 kann mit einem Schutzgas, z.B. $N_2$, erfolgen, wobei in vielen Anwendungsfällen ausreichend ist, lediglich die zweite Evakuierungskammer 108 mit Schutzgas zu belüften, während die erste Evakuierungskammer 110 mit Umgebungsluft belüftet wird. Die Prozeßkammer 2 wird regelmäßig lediglich beim Abschalten des integrierten Systems belüftet.

Das Fassungsvermögen der Evakuierungskammern 110, 108 ist derart ausgelegt, daß eine kontinuierliche Auslastung der Prozeßkammer 2 und der Lötvorrichtung 4 gewährleistet ist.

In der Prozeßkammer 2 ist im Bereich der Schleusen 16, 17 eine Beruhigungszone 124 ausgebildet, die jeweils über eine im Bereich des Fördersystems 6 offene Wandung 126 von der eigentlichen Plasmabehandlungs-Kammer 128 abgetrennt ist. Durch die Wandung 126 wird verhindert, daß das Prozeßgas bei offenen Schleusentoren 16, 17 ungehindert in die Evakuierungskammern 110, 108 abströmen kann. Dadurch ist in der Plasmabehandlungs-Kammer 128 eine in Transportrichtung X gesehen im wesentlichen gleichmäßige Prozeßgaskonzentration erzielbar. Darüber hinaus wird die Temperatur der Leiterplatten 10 in den Beruhigungszonen 124 vergleichmäßigt.

Wie beim ersten Ausführungsbeispiel ist auch die in Figur 2 gezeigte Prozeßkammer 2 mit Quarzglas ummantelt. Im Parallelabstand zum Fördersystem 6 sind in der oberen und unteren Deckfläche 130 der Plasmabehandlungs-Kammer 128 Magnetrone 132 angeordnet, über die die Hochfrequenzenergie zur Erzeugung des Gasplasmas eingeleitet wird.

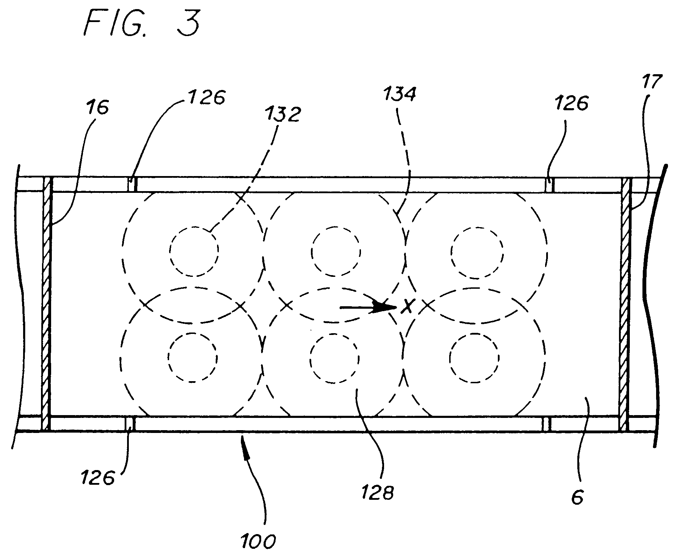

Gemäß Figur 3 sind die Magnetrone 132 derart über den Horizontalquerschnitt der Plasmabehandlungs-Kammer 128 verteilt, daß eine weitgehend gleichmäßige Verteilung des Gasplasmas erzielbar ist. Im gezeigten Ausführungsbeispiel sind den Deckflächen 130 jeweils zwei Reihen mit jeweils drei in Transportrichtung X hintereinanderliegenden Magnetronen 132 vorgesehen. Selbstverständlich lassen sich in Abhängigkeit von den Betriebsbedingungen auch andere Verteilungsmuster der Magnetrone 132 realisieren.

Es ist vorteilhaft, die Plasmabehandlungs-Kammer 128 zur Minimierung des Prozeßgasvolumens in Vertikalrichtung möglichst flach zu gestalten, wobei der Abstand der Deckflächen 130 zum Fördersystem 6 oder genauer gesagt zu den Großflächen der Leiterplatte 10 derart gewählt wird, daß sich die Wirkbereiche 134 der benachbarten Magnetrone 132 (s. gestrichelte Linien in Figur 2) zu einem nahezu flächendeckenden Bereich addieren. Auf diese Weise wird bei minimalem Gasvolumen eine optimale Wirkung des Gasplasmas erzielt. Selbst wenn sich die Wirkbereiche 134 nicht über die gesamte Behandlungsfläche erstrecken, ist noch eine hinreichende Plasmabehandlung der bestückten Leiterplatten 10 gewährleistet, da durch die Transportbewegung der Leiterplatten 10, durch die Reflexion in der Prozeßkammer 2 und die Impulsübertragung zwischen den Ionen des Prozeßgases eine über die Fläche einer Leiterplatte gleichmäßige Beaufschlagung der Fügepartner mit Gasplasma gewährleistet ist.

In den Figuren 2 und 3 nicht gezeigt sind die Gasanschlüsse, mit denen das Prozeßgas in die Prozeßkammer 2 eingeleitet wird, sowie Heizeinrichtungen, mit denen die Prozeßkammer 2 auf die Prozeßtemperatur gebracht wird.

An die erste Evakuierungskammer 110 schließt sich der Schutzgastunnel 112 an, in dem eine Schutzgasatmosphäre mit z.B. einem geringen $N_2$-Überdruck herrscht, so daß keine Umgebungsluft durch das Auslaßtor in diesen Abschnitt eindringen kann. Bei Bedarf kann eine Vorheizung 136 betrieben werden, mittels der die plasmabehandelten, bestückten Leiterplatten 10 auf eine geeignete Vorwärmtemperatur für den Lötvorgang in der Lötvorrichtung 4 gebracht werden, so daß eine thermische Schädigung der Leitplatten durch eine zu schnelle Erwärmung (thermischer Schock) im Lötbad vorgebeugt wird. Als Vorheizung 136 können z.B. Infrarot-Strahler eingesetzt werden, die in einem Abschnitt des Schutzgastunnels im Parallelabstand zur Förderstrecke 6 angeordnet sind.

Im gezeigten Ausführungsbeispiel wird als Lötvorrichtung eine an sich bekannte Doppelwellen-Lötvorrichtung verwendet, wie sie bereits im ersten Ausführungsbeispiel beschrieben wurde. Auch dieser Doppelwellen-Lötvorrichtung kann eine Schutzgasaufblasstation mit einer Breitschlitzdüse (nicht gezeigt) zugeordnet sein, durch die - wie im Zusammenhang mit dem ersten Ausführungsbeispiel beschrieben - eine Lötbrückenbildung weitgehend verhinderbar ist.

Im folgenden seien die wichtigsten Verfahrensschritte zur Verarbeitung von Leiterplatten mit einer Vorrichtung gemäß Figur 2 und 3 erläutert.

Eine betriebsbereite Lötvorrichtung 4 vorausgesetzt, wird vor Produktionsaufnahme zunächst die geschlossene Prozeßkammer 2 über die Vakuumpumpe 125 evakuiert und das sich in der Prozeßkammer 2 befindliche Prozeßgas in den Plasmazustand versetzt. Die zu verlötende Leiterplatte 10 oder, wie in Figur 2 gezeigt, eine Vielzahl von Leiterplatten 10 werden durch das geöffnete Einlaßtor 114 in die zweite Evakuierungskammer 108 gefördert. Diese wird bei geschlossenem Einlaßtor 114 auf den Prozeßdruck evakuiert, so daß beim Öffnen des Schleusentors 16 keine Verunreinigung des Prozeßgases in der Prozeßkammer 2 durch Umgebungsluft erfolgt und der Druck innerhalb der Prozeßkammer konstant bleibt. Nach dem Öffnen des Schleusentors 16 durchläuft die Leiterplatte 10 die Beruhigungszone 124, in der die Leiterplatte mit dem Prozeßgas beaufschlagt und auf die Prozeßtemperatur erwärmt wird.

Während sich die Leiterplatte 10 in der Beruhigungszone 124 befindet, wird die Schleuse 16 wieder geschlossen und die zweite Evakuierungskammer 108 z.B. mit Umgebungsluft belüftet, so daß eine neue Leiterplatte 10 durch das Einlaßtor 114 in den Tunnel 100 transportiert werden kann.

Inzwischen wird die auf einem Tragrahmen angeordnete Leiterplatte 10 durch die Wandung 126 in die Plasmabehandlungs-Kammer 128 gefördert. Obwohl die Beruhigungszonen 124 durch die Wandungen 126 nicht gasdicht von der Plasmabehandlungs-Kammer 128 abgetrennt sind, befindet sich das durch die Magnetrone 132 erzeugte Gasplasma im wesentlichen in der Plasmabehandlungs-Kammer 128, so daß in dieser die eigentliche Plasmabehandlung erfolgt.

Nach dem Durchlaufen der Plasmabehandlungs-Kammer 128 gelangt die Leiterplatte 10 durch die Wandung 126 in die ausgangsseitige Beruhigungszone 124, die ebenfalls weitgehend frei von Gasplasma ist. In der ausgangsseitigen Beruhigungszone 124 erfolgt der Abschluß der durch die Radikale des Gasplasmas hervorgerufenen Reaktionen mit den metallischen Oberflächen der Fügepartner und eine Vergleichmäßigung der Leiterplattentemperatur.

Bevor die behandelte Leiterplatte 10 durch die Schleuse 17 in die erste Evakuierungskammer 110 eintritt, wird diese auf den Prozeßdruck evakuiert. Nachdem sich die Leiterplatte 10 in der ersten Evakuierungskammer 110 befindet, wird das Schleusentor 17 geschlossen und die erste Evakuierungskammer 110 vorzugsweise mit Schutzgas belüftet.

Nach dem Öffnen des Ausgangs-Schleusentors 118 wir die Leiterplatte 10 durch den Schutzgastunnel 112 zur Doppelwellen-Lötvorrichtung 4 gefördert, in der die Fügepartner miteinander verlötet werden. Durch die Vorheizung 136 des Schutzgastunnels 160 werden die Leiterplatten 10, falls notwendig, auf die Vorwärmtemperatur für den Lötvorgang erwärmt. Bei genügend hohen Prozeßtemperaturen kann diese Vorwärmung entfallen, da alleine durch die Plasmabehandlung eine hinreichende Erwärmung der Leiterplatten 10 erfolgt.

Zwischenzeitlich wird das Ausgangs-Schleusentor 118 geschlossen und die erste Evakuierungskammer 110 evakuiert, so daß beim nächsten Öffnen des Schleusentors 17 keine Verunreinigung des Prozeßgases in der Prozeßkammer 2 und keine Veränderung des Prozeßdruckes erfolgt.

Durch die erste Evakuierungskammer 110 und den Schutzgastunnel 112 ist gewährleistet, daß allenfalls ein vernachlässigbarer Anteil von Luftsauerstoff in den Tunnelbereich zwischen der Lötvorrichtung 4 und der Prozeßkammer 2 eindringen kann, so daß einer Reoxidation der metallischen Oberfläche der Fügepartner (Leiterplatte, elektrische Bauelemente) vorgebeugt ist.

Die verlöteten Leiterplatten 10 treten durch den Auslaßbereich 116 und das Auslaßtor 115 aus dem Tunnel 100 heraus und werden, z.B. durch eine nicht gezeigte Übergabestation, dem nächsten Verarbeitungsschritt zugeführt.

Ergänzend sei angemerkt, daß bei der Verwendung von nicht reaktiven Prozeßgasen auf die Evakuierung der Evakuierungskammern 110 und 108 und auf die an deren Vakuumpumpen 125 angeschlossene Gaswäsche verzichtet werden kann.

Wie bereits erwähnt, kann anstelle der Doppelwellen-Lötvorrichtung auch eine nach einem anderen Prinzip arbeitende Lötvorrichtung, wie z.B. eine Reflow-Lötvorrichtung, eingesetzt werden.

Abschließend sei der Einfluß der Plasmavorbehandlung auf die Lötanschlußflächen von Bauelementen von Flachbaugruppen mit THM-, COB- und SMD-Bauelementen anhand von Laborversuchen in einer diskontinuierllich betriebenen Prozeßkammer beschrieben.

Für die Untersuchungen der Effizienz der Plasmavorbehandlung wurden die Bauelemente mit schmelzmetalurgischer SnPb-Schicht aus einem Alterungsspektrum ausgewählt, um die natürliche Oxidschichtdickenrelation der Bewertung zugänglich zu machen.

Auf einem wellenlötgerechten Leiterplatten-Layout wurden die THM-Bauformen formschlüssig fixiert. Die SMD-Bauformen wurden mittels eines SMD-Klebers fixiert und die Gesamtbaugruppe bei 120°C für 5 min zur Kleberaushärtung getempert. Eine Prozedur, die bezüglich einer additiven Passivschichtbildung unbedingt bewertet werden muß, zumal entweichende Lösungsmittelanteile des Klebers oder Kleberüberschuß zur ungewollten Passivierung von Lötanschlußflächen beitragen können.

Bei reinen SMD-Baugruppen oder COB/SMD-Baugruppen ist die Kleberfixierung der Bauelemente nicht zwingend notwendig, wenn eine hinreichende Lotquantität zur Verbindungsbildung bereitsteht und dieselbe oder das Pad konstruktive Elemente der Bauelementefixierung aufweisen.

Nachfolgend werden die mischbestückten oder reinen SMD-Baugruppen der Plasmavorbehandlung zugeführt. Als Vorbehandlungszeit in einer reinen $H_2$-Plasmaatmosphäre wurden Variationen zwischen einer Prozeßdauer von 2 bis 20 min, bei einem Plasmadruck von 100 Pa, einer Leistungsdichte von ca. 0,8 $W/cm^2$ untersucht.

Darüber hinaus wurde eine Plasmaatmosphäre von 95 Volumenanteilen $H_2$ / 5 Volumenanteilen $CH_4$ mit einer Prozeßdauer von 2 bis 10 min, einem Prozeßdruck von 100 Pa und einer Leistungsdichte von 0,6 $W/cm^2$ zur Anwendung gebracht. Die Flachbaugruppen wurden sofort nach der Vorbehandlung und nach einer Pufferzeit von 20 min zwischen Plasmavorbehandlung und Lötvorgang löttechnisch verarbeitet. Die visuelle Diagnostik wurde mit einer 20-X-Ray-Transmissionsanalyse gekoppelt, um die Fügezonen im Bauelementanschlußbereich hinreichend und eindeutig bewerten zu können. Es kann prüftechnisch attestiert werden, daß nach Durchführung eines zum Wellenlöten konzipierten Tauchtestes (Lot LSn63) das kapillare Eindringen des Lots selbst in Spalte um 100 µm gewährleistet ist, die Ausbildung der Meniskustopologie ein gutes Benetzungsverhalten erkennen läßt und die Fehlstellenfreiheit in der Grenzfläche Metallisierung/Lot mindestens die Quantität des herkömmlichen Wellenlötens unter Einsatz von Flußmitteln erreicht.

Die beschriebene Plasmavorbehandlung der Flachbaugruppe sichert hierbei u.a., daß die Durchkontaktierung der Leiterplatte bzw. die Kapillaren zum steckbaren Bauelementanschluß homogen und fehlerfrei mit Lot gefüllt sind.

Das Ergebnis von zerstörenden Prüfungen ist ebenso ein Indikator der Verbindungsqualität. Fehlbenetzungen sind nur dort zu erwarten, wo ein zur Bauformfixierung überdimensionierter Kleberpunkt Lötanschlußflächen der Plasmavorbehandlung entzogen hat. Schädigungen von Verkappungswerkstoffen und Verkappungsformen der Bauelemente durch die erfindungsgemäße Plasmavorbehandlung sind nicht zu erwarten bzw. wurden nicht festgestellt.

## Patentansprüche

1. Verfahren zur Verarbeitung von mit elektronischen Bauelementen bestückten Leiterplatten (10), das die Schritte umfaßt,
daß die bestückten Leiterplatten (10) einer Vorbehandlungsstation (2) zugeführt werden,
daß in der Vorbehandlungsstation (2) die bestückten Leiterplatten einer Vorbehandlung zur Erhöhung der Lötfreudigkeit unterzogen werden,
daß die vorbehandelten bestückten Leiterplatten (10) aus der Vorbehandlungsstation (2) zu einer Lötmaschine (4) gefördert werden und
daß unmittelbar im Anschluß an die Vorbehandlung die Bauelemente und die damit bestückten Leiterplatten (10) in der Lötmaschine (4) miteinander verlötet werden,
dadurch gekennzeichnet,
daß in der Vorbehandlungsstation, die durch eine Niederdruck-Prozeßkammer (2) gebildet ist, als Vorbehandlung der bestückten Leiterplatten (10) statt einer Behandlung mit einem Flußmittel eine Plasmabehandlung mit einem Prozeßgas erfolgt.

2. Verfahren nach Anspruch 1, dadurch gekennzeichnet, daß als Prozeßgas ein Stoff aus der Gruppe der $O_2$, $H_2$, $Cl_2$, $N_2O$, $N_2$, $CF_4$, Fluorkohlenwasserstoffe oder eine Kombination mehrerer dieser Stoffe eingesetzt wird.

3. Verfahren nach Anspruch 1, dadurch gekennzeichnet, daß als Prozeßgas ein Stoff aus der Gruppe der Edelgase, $H_2$ und alkylbildendes Gas oder eine Kombination mehrerer dieser Stoffe eingesetzt wird.

4. Verfahren nach Anspruch 3, dadurch gekennzeichnet, daß ein aus 100 bis 80 Volumenanteilen $H_2$ und aus 0 bis 20 Volumenanteilen eines alkylbildenden Gases bestehendes Prozeßgas verwendet wird.

5. Verfahren nach Anspruch 3, dadurch gekennzeichnet, daß ein aus 100 bis 80 Volumenanteilen $H_2$ und insgesamt 0 bis 20 Volumenanteilen eines Edelgases und eines alkylbildenden Gases bestehendes Prozeßgas verwendet wird.

6. Verfahren nach einem der Ansprüche 3 bis 5, dadurch gekennzeichnet, daß ein aus 95 Volumenanteilen $H_2$ und 5 Volumenanteilen $CH_4$ bestehendes Prozeßgas verwendet wird.

7. Verfahren nach Anspruch 2, dadurch gekennzeichnet, daß ein aus 5 Volumenanteilen $CF_4$ und 1 Volumenanteil $O_2$ bestehendes Prozeßgas verwendet wird.

8. Verfahren nach Anspruch 2, dadurch gekennzeichnet, daß ein aus 4 Volumenanteilen $O_2$ und 1 Volumenanteil $CF_4$ bestehendes Prozeßgas verwendet wird.

9. Verfahren nach einem der Ansprüche 1 bis 8, dadurch gekennzeichnet, daß zur Plasmavorbehandlung der mit elektronischen Bauelementen bestückten Leiterplatten ein Niederdruckplasma bei einem Prozeßdruck von weniger als $2 \cdot 10^4$ Pa, einer Plasmaleistungsdichte von mehr als 0,1 $W/cm^2$, einer Prozeßtemperatur von weniger als 180°C und einer Prozeßdauer von mehr als 10 s verwendet wird.

10. Verfahren nach Anspruch 9, dadurch gekennzeichnet, daß vorzugsweise ein Niederdruckplasma bei einem Prozeßdruck von 10 bis 200 Pa, einer Plasmaleistungsdichte von 0,5 bis 0,8 $W/cm^2$, einem Prozeßgasvolumenstrom zwischen 1 und 5000 ml/min, einer Prozeßtemperatur zwischen 60 und 100°C und einer Prozeßdauer zwischen 30 s und 10 min verwendet wird.

11. Verfahren nach einem der Ansprüche 1 bis 10, dadurch gekennzeichnet, daß die bestückten Leiterplatten im Anschluß an die Plasmabehandlung zwischengespeichert werden.

12. Verfahren nach Anspruch 11, dadurch gekennzeichnet, daß die Zwischenspeicherung unter einer Schutzgasatmosphäre erfolgt.

13. Verfahren nach Anspruch 11 oder 12, dadurch gekennzeichnet, daß während der Zwischenspeicherung eine Temperierung der bestückten Leiterplatten erfolgt.

14. Verfahren nach einem der Ansprüche 1 bis 13, dadurch gekennzeichnet, daß die bestückten Leiterplatten durch die Plasmabehandlung auf eine für den Lötvorgang geeignete Vorwärmtemperatur erwärmt werden.

15. Verfahren nach einem der Ansprüche 1 bis 14, dadurch gekennzeichnet, daß die bestückten Leiterplatten (10) zwischen der Plasmabehandlung und dem Lötvorgang mit einem Schutzgas beaufschlagt werden.

16. Verfahren nach einem der Ansprüche 1 bis 15, dadurch gekennzeichnet, daß die Plasmabehandlung der bestückten Leiterplatten in einer abschnittsweise betriebenen, geschlossenen Prozeßkammer (2) durchgeführt wird.

17. Verfahren nach einem der Ansprüche 1 bis 15, dadurch gekennzeichnet, daß die Plasmabehandlung der bestückten Leiterplatten in einer kontinuierlich betriebenen Prozeßkammer (2) durchgeführt wird.

18. Verfahren nach einem der Ansprüche 1 bis 17, dadurch gekennzeichnet, daß die Plasmavorbehandlung der Bauelemente und Leiterplatten an reinen SMD-Baugruppen oder gemischtbestückten COB/SMD-Baugruppen durchgeführt wird, wobei die Bauelementefixierung bei SMDs über Kleber auf erhabenen SnPb-Schichten oder profilierten und erhabenen SnPb-Schichten auf den Lötanschlußflächen der Leiterplatte und bei COBs durch konstruktive Maßnahmen in der Fügezone erfolgt.

19. Verfahren nach einem der Ansprüche 1 bis 18, dadurch gekennzeichnet, daß in der Prozeßkammer (2) eine Vielzahl von bestückten Leiterplatten (10) gleichzeitig einer Plasmabehandlung unterzogen werden.

20. Vorrichtung zur Durchführung des Verfahrens nach einem der vorhergehenden Ansprüche, mit einer Vorbehandlungsstation (2), in der die mit elektronischen Bauteilen bestückten Leiterplatten (10) einer Vorbehandlung zur Erhöhung der Lötfreudigkeit unterziehbar sind, und
einer Fördereinrichtung (6), mit der die vorbehandelten bestückten Leiterplatten (10) aus der Vorbehandlungsstation (2) zu einer Lötvorrichtung (4) transportierbar sind, in der sie miteinander verlötbar sind,
dadurch gekennzeichnet, daß die Vorbehandlungsstation (2) eine Prozeßkammer (2) zur Plasmavorbehandlung der bestückten Leiterplatten (10) umfaßt.

21. Vorrichtung nach Anspruch 20, dadurch gekennzeichnet, daß die Prozeßkammer eine Niederdruck-Prozeßkammer (2) ist.

22. Vorrichtung nach Anspruch 20 und 21, gekennzeichnet durch Schleusen (16,17), mittels denen die Prozeßkammer (2) absperrbar ist.

23. Vorrichtung nach einem der Ansprüche 20 bis 22, dadurch gekennzeichnet, daß der Prozeßkammer (2) ein erster Zwischenspeicher (110) zur Aufnahme der plasmabehandelten bestückten Leiterplatten (10) zugeordnet ist, aus dem diese der Lötvorrichtung (4) zuführbar sind.

24. Vorrichtung nach einem der Ansprüche 20 bis 23, dadurch gekennzeichnet, daß der Prozeßkammer (2) ein zweiter Zwischenspeicher (108) zur Aufnahme der in der Prozeßkammer (2) zu behandelnden bestückten Leiterplatten (10) zugeordnet ist.

25. Vorrichtung nach Anspruch 23 oder 24, dadurch gekennzeichnet, daß der erste und der zweite Zwischenspeicher (110, 108) über jeweils eine Schleuse (16,17) von der Prozeßkammer (2) abgetrennt sind und ihrerseits über jeweils eine weitere Schleuse (114, 118) absperrbar sind.

26. Vorrichtung nach einem der Ansprüche 20 bis 25, dadurch gekennzeichnet, daß an den Deckflächen (130) der Prozeßkammer (2) eine Vielzahl von Hochfrequenzgeneratoren (132) zur Erzeugung des Gasplasmas angeordnet sind, so daß die bestückten Leiterplatten im wesentlichen gleichmäßig mit dem Gasplasma beaufschlagbar sind.

27. Vorrichtung nach Anspruch 26, dadurch gekennzeichnet, daß die Hochfrequenzgeneratoren (132) im Parallelabstand zu den unteren und/oder oberen Großflächen der bestückten Leiterplatten (10) angeordnet sind.

28. Vorrichtung nach einem der Ansprüche 25 bis 27, dadurch gekennzeichnet, daß der erste und der zweite Zwischenspeicher (110, 108) jeweils über eine Vakuumpumpe (125) evakuierbar und belüftbar sind.

29. Vorrichtung nach Anspruch 28, dadurch gekennzeichnet, daß der erste Zwischenspeicher (110) und/oder der zweite Zwischenspeicher (108) mit Schutzgas belüftbar sind.

30. Vorrichtung nach einem der Ansprüche 23 bis 29, dadurch gekennzeichnet, daß im Anschluß an den ersten Zwischenspeicher (110) ein Schutzgastunnel (112) ausgebildet ist, durch den die bestückten Leiterplatten der Lötvorrichtung (4) zuführbar sind.

**31.** Vorrichtung nach Anspruch 30, dadurch gekennzeichnet, daß die Prozeßkammer (2) und die Lötvorrichtung (4) in einem gemeinsamen Durchlauftunnel (100) angeordnet sind, durch den die bestückten Leiterplatten (10) mittels eines gemeinsamen Fördersystems (106) förderbar sind und dessen Ein- und Ausgangsöffnung durch ein Einlaß- bzw. Auslaßtor (114,115) verschließbar sind.

**32.** Vorrichtung nach Anspruch 31, dadurch gekennzeichnet, daß der erste Zwischenspeicher (110) im Durchlauftunnel (100) angeordnet ist.

**33.** Vorrichtung nach Anspruch 31 oder 32, dadurch gekennzeichnet, daß der zweite Zwischenspeicher (108) im Durchlauftunnel (100) angeordnet ist.

**34.** Vorrichtung nach einem der Ansprüche 31 bis 33, dadurch gekennzeichnet, daß der Schutzgastunnel (112) im Durchlauftunnel (100) angeordnet ist.

**35.** Vorrichtung nach einem der Ansprüche 20 bis 34, dadurch gekennzeichnet, daß der in Transportrichtung (X) gesehen eingangs- und ausgangsseitige Abschnitt der Prozeßkammer (2) jeweils als eine Beruhigungszone (124) ausgebildet ist, in deren Bereich kein Energieeintrag erfolgt.

**36.** Vorrichtung nach einem der Ansprüche 20 bis 35, dadurch gekennzeichnet, daß jede Leiterplatte (10) während des Transports auf einem Hilfsrahmen des Fördersystems (106) positionierbar ist.

**37.** Vorrichtung nach einem der Ansprüche 20 bis 36, gekennzeichnet durch ein Stapelmagazin (12), in dem eine Vielzahl von bestückten Leiterplatten (10) angeordnet sind.

**38.** Vorrichtung nach einem der Ansprüche 20 bis 37, dadurch gekennzeichnet, daß der Lötvorrichtung (4) eine Schutzgasaufblasstation (5) zugeordnet ist, mittels der die von Lot benetzten Abschnitte der bestückten Leiterplatten (10) mit einem Schutzgas, insbesondere $N_2$, beaufschlagbar sind.

**39.** Vorrichtung nach einem der Ansprüche 20 bis 38, dadurch gekennzeichnet, daß die Lötvorrichtung (4) eine Doppelwellen-Lötvorrichtung ist.

**40.** Vorrichtung nach einem der Ansprüche 20 bis 39, dadurch gekennzeichnet, daß die Lötvorrichtung (4) eine Reflow-Lötvorrichtung ist.

**Claims**

**1.** Method for processing printed circuit boards (10) assembled with electronic components and comprising the steps,
that the assembled circuit boards (10) are supplied to a pretreatment station (2),
that in the pretreatment station (2) the assembled circuit boards undergo a pretreatment for facilitating soldering,
that the pretreated, assembled circuit boards (10) are conveyed from the pretreatment station (2) to a soldering machine (4) and
that immediately following onto the pretreatment the components and the circuit boards (10) assembled therewith are soldered together in the soldering machine (4),
characterized in that,
in the pretreatment station, which is formed by a low pressure process chamber (2), there is a plasma treatment with a process gas instead of a treatment with a flux as the pretreatment of the assembled circuit boards (10).

**2.** Method according to claim 1, characterized in that the process gas is a substance chosen from the group of $O_2$, $H_2$, $Cl_2$, $N_2O$, $N_2$, $CF_4$, fluorocarbons or a combination of several of these substances.

**3.** Method according to claim 1, characterized in that the process gas is a substance chosen from the group of inert gases, $H_2$ and alkyl-forming gas or a combination of several of these substances.

**4.** Method according to claim 3, characterized in that a process gas comprising 100 to 80 volume parts $H_2$ and 0 to 20 volume parts of an alkyl-forming gas is used.

**5.** Method according to claim 3, characterized in that a process gas comprising 100 to 80 volume parts $H_2$, in all 0 to 20 volume parts of an inert gas and an alkyl-forming gas is used.

**6.** Method according to one of the claims 3 to 5, characterized in that a process gas comprising 95 volume parts $H_2$ and 5 volume parts $CH_4$ is used.

**7.** Method according to claim 2, characterized in that a process gas comprising 5 volume parts $CH_4$ and 1 volume part $O_2$ is used.

**8.** Method according to claim 2, characterized in that a process gas comprising 4 volume parts $O_2$ and 1 volume part $CF_4$ is used.

**9.** Method according to one of the claims 1 to 8, characterized in that for the plasma pretreatment of the circuit boards assembled with the electronic components use is made of a low pressure plasma at a process pressure of less than $2.10^4$ Pa, a plasma power density of more than $0.1$ W/cm$^2$, a process temperature of less than 180°C and a process duration of more than 10 s.

10. Method according to claim 9, characterized in that preferably use is made of a low pressure plasma at a process pressure of 10 to 200 Pa, a plasma power density of 0.5 to 0.8 $W/cm^2$, a process gas volume flow between 1 and 5000 ml/min, a process temperature between 60 and 100°C and a process duration between 30 s and 10 min.

11. Method according to one of the claims 1 to 10, characterized in that, following onto the plasma treatment, the assembled circuit boards are temporarily stored.

12. Method according to claim 11, characterized in that the temporary storage takes place under a shielding gas atmosphere.

13. Method according to claim 11 or 12, characterized in that there is a thermal conditioning of the assembled circuit boards during the temporary storage.

14. Method according to one of the claims 1 to 13, characterized in that the assembled circuit boards are heated to a preheating temperature suitable for the soldering process by the plasma treatment.

15. Method according to one of the claims 1 to 14, characterized in that between the plasma treatment and the soldering process the assembled circuit boards (10) are subject to the action of a shielding gas.

16. Method according to one of the claims 1 to 15, characterized in that the plasma treatment of the assembled circuit boards takes place in a portionwise operated, closed process chamber (2).

17. Method according to one of the claims 1 to 15, characterized in that the plasma treatment of the assembled circuit boards takes place in a continuously operated process chamber (2).

18. Method according to one of the claims 1 to 17, characterized in that the plasma pretreatment of the components and the printed circuit boards is performed on purely SMD components or mixed-assembled COB/SMD components, the component fixing in the case of SMDs taking place by means of adhesive on raised SnPb coatings or profiled and raised SnPb coatings on the solder connection faces of the circuit board and with COBs by constructive measures in the joint zone.

19. Method according to one of the claims 1 to 18, characterized in that in the process chamber (2) a plurality of assembled circuit boards (10) simultaneously undergo a plasma treatment.

20. Apparatus for performing the method according to one of the preceding claims, with a pretreatment station (2) in which the printed circuit boards (10) assembled with the electronic components can undergo a pretreatment for facilitating soldering and a conveying mechanism (6) with which the pretreated, assembled circuit boards (10) are conveyable from the pretreatment station (2) to a soldering device (4) in which they can be soldered together, characterized in that the pretreatment station (2) comprises a process chamber (2) for the plasma pretreatment of the assembled circuit boards (10).

21. Apparatus according to claim 20, characterized in that the process chamber is a low pressure process chamber (2).

22. Apparatus according to claim 20 and 21, characterized by locks (16, 17) by means of which the process chamber (2) can be shut off.

23. Apparatus according to one of the claims 20 to 22, characterized in that with the process chamber (2) is associated a first temporary store (110) for receiving the plasma-treated, assembled circuit boards (10) and from which said circuit boards can be supplied to the soldering device (4).

24. Apparatus according to one of the claims 20 to 23, characterized in that with the process chamber (2) is associated a second temporary store (108) for receiving the assembled circuit boards (10) to be treated in the process chamber (2).

25. Apparatus according to claim 23 or 24, characterized in that the first and second temporary stores (110, 108) are in each case separated by a lock (16, 17) from the process chamber (2) and can in turn be shut off by in each case one further lock (114, 118).

26. Apparatus according to one of the claims 20 to 25, characterized in that on the top surfaces (130) of the process chamber (2) is provided a plurality of high frequency generators (132) for generating the gas plasma, so that the assembled circuit boards can be uniformly subject to gas plasma action.

27. Apparatus according to claim 26, characterized in that the high frequency generators (132) are parallel spaced from the lower and/or upper lower faces of the assembled circuit boards (10).

28. Apparatus according to one of the claims 25 to 27, characterized in that the first and the second temporary stores (110, 108) can in each case be evacuated and ventilated by means of a vacuum pump (125).

29. Apparatus according to claim 28, characterized in that the first temporary store (110) and/or the second temporary store (108) can be ventilated with shielding gas.

30. Apparatus according to one of the claims 23 to 29, characterized in that following onto the first temporary store (110) is formed a shielding gas tunnel (112) through which the assembled circuit boards can be supplied to the soldering device (4).

31. Apparatus according to claim 30, characterized in that the process chamber (2) and the soldering device (4) are located in a common continuous passage tunnel (100), through which the assembled circuit boards (10) can be conveyed by means of a common conveying system (106) and whose entrance and exit opening can be closed by an entrance or exit door (114, 115).

32. Apparatus according to claim 31, characterized in that the first temporary store (110) is located in the continuous passage tunnel (100).

33. Apparatus according to claim 31 or 32, characterized in that the second temporary store (108) is located in the continuous passage tunnel (100).

34. Apparatus according to one of the claims 31 to 33, characterized in that the shielding gas tunnel (112) is located in the continuous passage tunnel (100).

35. Apparatus according to one of the claims 20 to 34, characterized in that the entrance and exit-side portion of the process chamber (2) in the conveying direction (X) is in each case constructed as a calming zone (124), in whose vicinity no energy introduction takes place.

36. Apparatus according to one of the claims 20 to 35, characterized in that during the conveying operation, each circuit board (10) can be positioned on an auxiliary frame of the conveying system (106).

37. Apparatus according to one of the claims 20 to 36, characterized by a stacking magazine (12), in which are located a plurality of assembled circuit boards (10).

38. Apparatus according to one of the claims 20 to 37, characterized in that with the soldering device (4) is associated a shielding gas blowing station (5) by means of which the solder-covered portions of the assembled circuit boards (10) can be subject to the action of a shielding gas, particularly $N_2$.

39. Apparatus according to one of the claims 20 to 38, characterized in that the soldering device (4) is a double wave soldering device.

40. Apparatus according to one of the claims 20 to 39, characterized in that the soldering device (4) is a reflow soldering device.

**Revendications**

1. Procédé de traitement de cartes imprimées (10) équipées de composants électroniques, comprenant les étapes suivantes :

    . on amène les cartes imprimées (10) équipées à un poste de préparation (2) ;
    . on soumet au poste de préparation (2) les cartes imprimées équipées à une opération préparatoire, afin d'augmenter leur compatibilité au brasage ou au soudage ;
    . on amène les cartes imprimées équipées ayant subi l'opération préparatoire depuis le poste de préparation jusqu'à un appareil de brasage ou soudage ;
    . on brase ou on soude les composants et les cartes imprimées (10) équipées de ces derniers immédiatement après l'opération préparatoire ;

    caractérisé en ce qu'au poste de préparation, constitué par une chambre opératoire à basse pression (2), on réalise un traitement au plasma au moyen d'un gaz opératoire, au lieu d'un traitement au moyen d'un flux, comme opération préparatoire des cartes imprimées (10) équipées.

2. Procédé selon la revendication 1, caractérisé en ce que l'on utilise comme gaz opératoire un représentant du groupe formé par $O_2$, $H_2$, $Cl_2$, $N_2O$, $N_2$, $CF_4$, un fluorure d'hydrocarbure, ou une combinaison de plusieurs de ces éléments.

3. Procédé selon la revendication 1, caractérisé en ce que l'on utilise comme gaz opératoire un représentant du groupe formé des gaz nobles, $H_2$ et un gaz formant un alcoyle, ou une combinaison de plusieurs de ces éléments.

4. Procédé selon la revendication 3, caractérisé en ce que l'on utilise un gaz opératoire constitué de 100 à 80 parties en volume de $H_2$ et de zéro à 20 parties en volume d'un gaz formant un alcoyle.

5. Procédé selon la revendication 3, caractérisé en ce que l'on utilise un gaz opératoire constitué de 100 à 80 parties en volume de $H_2$ et de zéro à 20 parties en volume d'un gaz noble et d'un gaz formant un alcoyle.

6. Procédé selon l'une des revendications 3 à 5, caractérisé en ce que l'on utilise un gaz opératoire constitué de 95 parties en volume de $H_2$ et 5 parties en volume de $CH_4$.

**7.** Procédé selon la revendication 2, caractérisé en ce que l'on utilise un gaz opératoire constitué de 5 parties en volume de $CF_4$ et une partie en volume de $O_2$.

**8.** Procédé selon la revendication 2, caractérisé en ce que l'on utilise un gaz opératoire constitué de 4 parties en volume de $O_2$ et une partie en volume de $CF_4$.

**9.** Procédé selon l'une des revendications 1 à 8, caractérisé en ce que l'on utilise pour le traitement au plasma des cartes imprimées équipées de composants électroniques un plasma à basse pression, avec une pression opératoire inférieure à $2.10^4$ Pa, une puissance volumique du plasma supérieure à 0,1 W/cm2, une température opératoire inférieure à 180°C et une durée opératoire supérieure à 10 s.

**10.** Procédé selon la revendication 9, caractérisé en ce que l'on utilise de préférence un plasma à basse pression, avec une pression opératoire de 10 à 200 Pa, une puissance volumique du plasma de 0,5 à 0,8 W/cm2, une température opératoire de 60 à 100°C et une durée opératoire de 30 s à 10 mn.

**11.** Procédé selon l'une des revendications 1 à 10, caractérisé en ce que l'on effectue un stockage intermédiaire des cartes imprimées équipées à la suite du traitement au plasma.

**12.** Procédé selon la revendication 11, caractérisé en ce que le stockage intermédiaire est effectué sous une atmosphère de gaz inerte.

**13.** Procédé selon l'une des revendications 11 ou 12, caractérisé en ce que l'on réalise un équilibrage de la température des cartes imprimées équipées pendant le stockage intermédiaire.

**14.** Procédé selon l'une des revendications 1 à 13, caractérisé en ce que les cartes imprimées équipées sont réchauffées par le traitement au plasma jusqu'à une température de préchauffage adaptée pour l'opération de brasage ou de soudage.

**15.** Procédé selon l'une des revendications 1 à 10, caractérisé en ce que l'on soumet les cartes imprimées (10) équipées à une injection de gaz inerte entre le traitement au plasma et l'opération de brasage ou de soudage.

**16.** Procédé selon l'une des revendications 1 à 15, caractérisé en ce que l'on effectue le traitement au plasma des cartes imprimées équipées dans une chambre opératoire (2) fermée fonctionnant par sections.

**17.** Procédé selon l'une des revendications 1 à 15, caractérisé en ce que l'on effectue le traitement au plasma des cartes imprimées équipées dans une chambre opératoire (2) fonctionnant en continu.

**18.** Procédé selon l'une des revendications 1 à 17, caractérisé en ce que l'on effectue le traitement préliminaire au plasma des composants et de la carte imprimée sur des groupes constructifs équipés uniquement en SMD, ou sur des groupes constructifs équipés de façon mélangée en COB/SMD, en solidarisant les composants, pour des SMD, par l'intermédiaire de colle sur des couches SnPb bosselées ou des couches SnPb profilées et bosselées, et pour des COB, par des mesures constructives dans la zone d'assemblage.

**19.** Procédé selon l'une des revendications 1 à 18, caractérisé en ce que l'on soumet simultanément à un traitement au plasma dans la chambre opératoire (2) un nombre élevé de cartes imprimées (10) équipées.

**20.** Dispositif pour la mise en oeuvre du procédé selon l'une des revendications précédentes, comprenant un poste de préparation (2), dans lequel les cartes imprimées (10) équipées de composants électroniques peuvent être soumises à une opération préparatoire pour augmenter leur compatibilité au brasage ou au soudage, et un dispositif de transport (6), au moyen duquel les cartes imprimées (10) équipées peuvent être transportées après l'opération préparatoire depuis le poste de préparation jusqu'à un dispositif de brasage ou soudage (4), dans lequel elles peuvent être solidarisées par brasage ou soudage, caractérisé en ce que le poste de préparation (2) comprend une chambre opératoire (2) pour un traitement préliminaire au plasma des cartes imprimées (10) équipées.

**21.** Dispositif selon la revendication 20, caractérisé en ce que la chambre opératoire est une chambre opératoire à basse pression (2).

**22.** Dispositif selon les revendications 20 et 21, caractérisé par des sas (16, 17) au moyen desquels la chambre opératoire (2) est susceptible d'être obturée.

**23.** Dispositif selon l'une des revendications 20 à 22, caractérisé en ce qu'à la chambre opératoire (2) est associé un premier dispositif de stockage intermédiaire (110) pour recevoir les cartes imprimées (10) équipées, à partir duquel ces dernières peuvent être conduites jusqu'au dispositif de brasage ou soudage (4).

**24.** Dispositif selon l'une des revendications 20 à 23, caractérisé en ce qu'à la chambre opératoire (2) est associé un second dispositif de stockage intermédiaire (108) pour recevoir les cartes imprimées (10) équipées devant subir l'opération préliminaire.

25. Dispositif selon l'une des revendications 23 ou 24, caractérisé en ce que le premier et le second dispositifs de stockage intermédiaire (110, 108) sont séparés chacun de la chambre opératoire (2) par un sas (16, 17), et peuvent de leur côté être fermés chacun par l'intermédiaire d'un sas supplémentaire (114, 118).

26. Dispositif selon l'une des revendications 20 à 25, caractérisé en ce que sur les surfaces de recouvrement (130) de la chambre opératoire (2) sont disposés un nombre élevé de générateurs à haute fréquence (132) pour produire le plasma gazeux, de façon que les cartes imprimées équipées puissent être soumises à l'injection du plasma gazeux de manière sensiblement régulière.

27. Dispositif selon la revendication 26, caractérisé en ce que les générateurs à haute fréquence (132) sont disposés selon un écartement parallèlement aux grandes surfaces inférieures et/ou supérieures des cartes imprimées (10) équipées.

28. Dispositif selon l'une des revendications 25 à 27, caractérisé en ce que le premier et le second dispositifs de stockage intermédiaire (110, 108) peuvent être mis sous vide et ventilés chacun par l'intermédiaire d'une pompe à vide (125).

29. Dispositif selon la revendication 28, caractérisé en ce que le premier dispositif de stockage intermédiaire (110) et/ou le second dispositif de stockage intermédiaire (108) peuvent être ventilés au moyen d'un gaz inerte.

30. Dispositif selon l'une des revendications 23 à 29, caractérisé en ce qu'à la suite du premier dispositif de stockage intermédiaire (110) est conformé un tunnel de gaz inerte, à travers lequel les cartes imprimées équipées peuvent être transportées jusqu'au dispositif de brasage ou soudage (4).

31. Dispositif selon la revendication 30, caractérisé en ce que la chambre opératoire (2) et le dispositif de brasage ou soudage (4) sont disposés dans un tunnel commun de passage en continu (100), à travers lequel les cartes imprimées (10) peuvent être transportées au moyen d'un système de transport (106) commun, et dont les ouvertures d'entrée et de sortie peuvent être fermées respectivement par une porte d'entrée et par une porte de sortie (114, 115).

32. Dispositif selon la revendication 31, caractérisé en ce que le premier dispositif de stockage intermédiaire (110) est disposé dans le tunnel de passage en continu (100).

33. Dispositif selon la revendication 31 ou 32, caractérisé en ce que le second dispositif de stockage intermédiaire (108) est disposé dans le tunnel de passage en continu (100).

34. Dispositif selon l'une des revendications 31 à 33, caractérisé en ce que le tunnel de gaz de protection (112) est disposé dans le tunnel de passage en continu (100).

35. Dispositif selon l'une des revendications 20 à 34, caractérisé en ce que chacune des sections de la chambre opératoire (2) situées du côté de l'entrée et du côté de la sortie, considéré dans le sens du transport (X), est conformée comme une zone de stabilisation (124) au niveau de laquelle il ne se produit aucun apport d'énergie.

36. Dispositif selon l'une des revendications 20 à 35, caractérisé en ce que chaque carte imprimée (10) peut être placée pendant le transport sur un cadre support du système de transport (106).

37. Dispositif selon l'une des revendications 20 à 36, caractérisé par un magasin d'empilage (12) dans lequel un nombre élevé de cartes imprimées (10) équipées sont disposées.

38. Dispositif selon l'une des revendications 20 à 37, caractérisé par le fait qu'au dispositif de brasage ou soudage (4) est associé un poste d'insufflation de gaz inerte, au moyen duquel les parties imprégnées d'apport de brasage ou soudage des cartes imprimées (10) équipées peuvent être soumises à un gaz inerte, en particulier $N_2$.

39. Dispositif selon l'une des revendications 20 à 38, caractérisé en ce que le dispositif de brasage ou soudage (4) est un dispositif de brasage ou soudage à double vague.

40. Dispositif selon l'une des revendications 20 à 39, caractérisé en ce que le dispositif de brasage ou soudage (4) est un dispositif de brasage ou soudage par refusion.

FIG. 1

# FIG. 2

EP 0 427 020 B1

FIG. 3

EP 0 427 020 B1